# EUROPEAN PATENT SPECIFICATION

(11) **EP 0 499 824 B1**
(45) Date of publication and mention of the grant of the patent: **25.09.1996**
(21) Application number: 92101131.8
(22) Date of filing: 24.01.1992
(51) Int. Cl.: G11C 11/412

(54) **Stacked capacitor SRAM cell**
SRAM-Zelle mit geschichteter Kapazität
Cellule SRAM à capacité superposée

(30) Priority: 30.01.1991 US 647879
(43) Date of publication of application: 26.08.1992
(73) Proprietor: TEXAS INSTRUMENTS INCORPORATED, Dallas Texas 75265 (US)
(72) Inventor: Rodder, Mark S., University Park, Texas 75205 (US)
(74) Representative: Leiser, Gottfried, Dipl.-Ing.

(56) References cited:
- EP-A- 0 320 405
- US-A- 4 679 171
- US-A- 4 970 564
- US-A- 4 984 200

## Description

### NOTICE

(C) Copyright, *M* Texas Instruments incorporated 1991. A portion of the disclosure of this patent document contains material which is subject to copyright and mask work protection. The copyright and mask work owner has no objection to the facsimile reproduction by anyone of the patent document or the patent disclosure, as it appears in the Patent and Trademark Office patent file or records, but otherwise reserves all copyright and mask work rights whatsoever.

### FIELD OF THE INVENTION

This invention generally relates to semiconductor fabrication methods and devices, and more specifically to static random access memory (SRAM) cell fabrication methods and devices. US-A-4 984 200 shows an SRAM cell using two cross-coupled resistive load MOS inverters. Each storage node is connected with a capacitor. The individual other electrodes of the capacitors are connected with a fixed reference potential. The capacitors are constructed to increase the charge storage capability of the information storage nodes.

### BACKGROUND OF THE INVENTION

One approach to a SRAM cell is to use two coupled CMOS inverters (which is similar to an NMOS cell but with the load transistors in the NMOS cell replaced with PMOS transistors). The CMOS cell will require more area but the power consumption when the circuit is quiescent will be virtually eliminated. One method to improve the packing density of CMOS. SRAMs is to stack the transistors one on top of another. This arrangement allows the circuit design to extend into the third dimension.

Low stand-by power and high speed operation are key factors for the next generation of SRAMs. In addition, high packing density SRAMs exhibit serious soft error problems under high speed operation. The storage node voltage tends to drop as the operation speed is increased. This voltage drop can allow alpha particles to cause soft errors.

### SUMMARY OF THE INVENTION

This is an SRAM cell. The cell comprises: two NMOS drive transistors; two PMOS load transistors; said transistors forming two cross-coupled CMOS inverters first and second bottom capacitor plates, with the first plate being positioned over and connected to a gate of one of the drive transistors and the second plate being positioned over and connected to a gate of another one of the drive transistors; a layer of dielectric material over the first and second bottom capacitor plates; and
first and second top capacitor plates being positioned over the dielectric layer, with the first top capacitor plate forming a gate of one of the load transistors and with the second top capacitor plate forming a gate of another one of the load transistors, whereby the capacitor plates form two capacitors connected in parallel between the gates of the drive transistors and the stability of the cell is enhanced. Preferably the dielectric material is oxide, nitride, tantalum oxide, or oxide and nitride.

This is also a method of forming an SRAM cell, by forming first and second NMOS drive transistors, and first and second PMOS load transistors, said transistors forming two cross-coupled CMOS inverters. The method further comprises: forming a first bottom capacitor plate being positioned over a gate of the second drive transistor and second bottom capacitor plate being positioned over a gate of the first drive transistor; electrically connecting the first bottom capacitor plate to the second drive transistors gate; electrically connecting the second bottom capacitor plate to the first drive transistor gate; forming dielectric layer over the first and second bottom capacitor plates; forming first and second top capacitor plates over the dielectric layer, with the first top capacitor plate forming a gate of the first load transistor and being positioned over the first bottom capacitor plate, and the second top capacitor plate forming a gate of the second load transistor and being positioned over the second bottom capacitor plate; electrically connecting the first top capacitor plate to the first drive transistor gate; electrically connecting the second top capacitor plate to the second drive transistor gate; and forming PMOS channel films over the first and second top capacitor plates.

Preferably the first and second bottom capacitor plates are fabricated from silicon; the first and second top capacitor plates are fabricated from silicon; the first and second bottom capacitor plates are over gate sidewalls of the drive transistors; the first and second top capacitor plates are over gate sidewalls of the drive transistors; and the dielectric layer is oxide, nitride, tantalum oxide, or oxide and nitride.

### BRIEF DESCRIPTION OF THE DRAWINGS

In the drawings:
FIGS. 1a-1c are layout views of a preferred embodiment of this invention, during sequential processing steps;
FIG. 2 is a cross-sectional view along line a-a of FIG. 1a after subsequent processing steps;
FIG. 3 is a schematic diagram of a preferred embodiment of this invention;

### DETAILED DESCRIPTION OF PREFERRED EMBODIMENTS

As SRAM cell size decreases, the possibility of soft error increases due to lower cell capacitance. One technique to reduce soft error rate (SER) is to increase the cell capacitance. In particular, it is known that increasing the coupling capacitance between drive transistor gates results in a large reduction in SER without significantly decreasing access time. SRAM cells have been designed, using PMOS transistors stacked atop NMOS transistors, which increases such cross-coupling. However, this coupling capacitance is substantially larger than in previous SRAM cells if the effective area of elements (which contribute that capacitance) is increased (previously, the PMOS transistors were stacked, but conventional element sizes were used). The intent of this embodiment is to increase the aforementioned capacitance by such increases in effective area (and possibly, changes in the dielectric between such elements). The addition of capacitor plates is a practical way to increase the effective area.

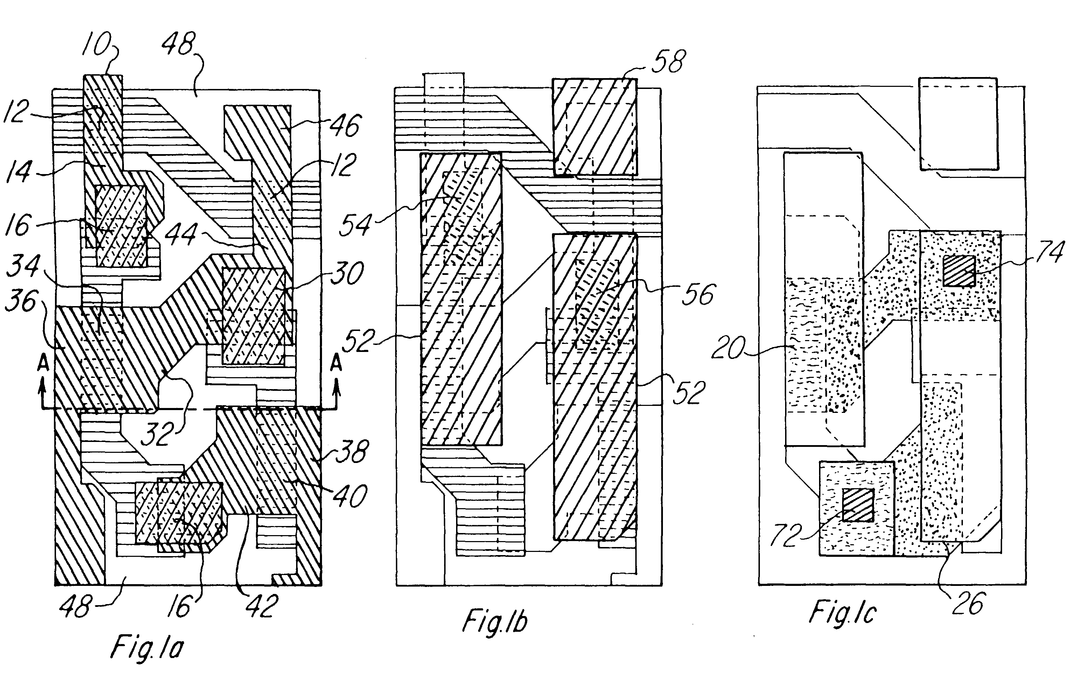

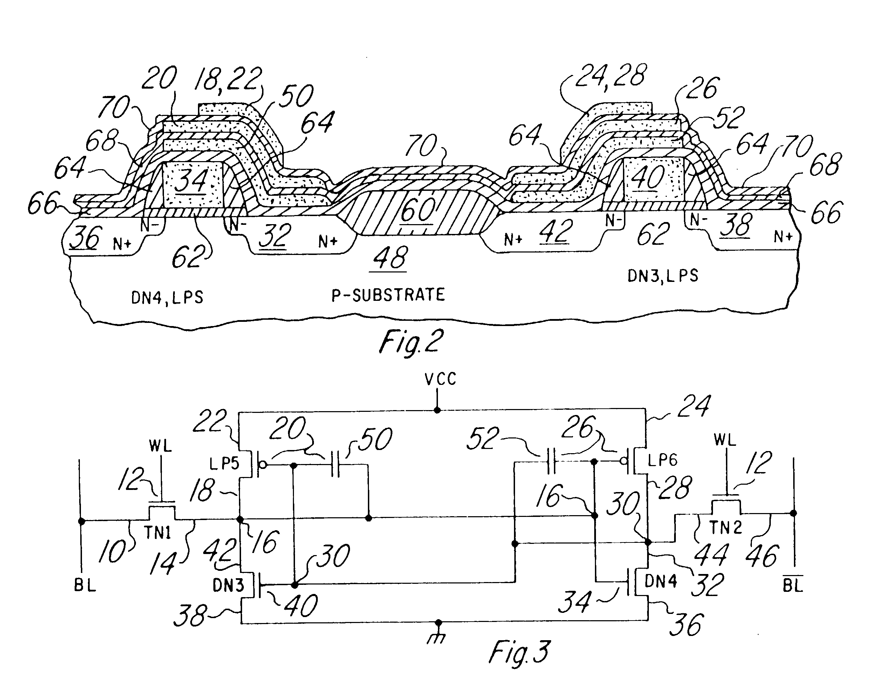

A preferred embodiment of the present invention is shown, in FIGS. 1a-1c, during sequential processing steps. A cross-section (FIG. 2) and a schematic (FIG. 3) of this preferred embodiment are provided for clarification, and should be referred to when examining FIGS. 1a-1c. Table 1 below may also be used as a reference for the drawings. FIG. 1a shows the layout after formation of standard CMOS or BiCMOS well 48, formation of active regions (which includes the moat regions), the formation of drive transistor (DN3, DN4) gate regions 34,40, the formation of the access/transfer transistors (TN1, TN2) gate region 12, and the formation of gate to moat interconnects 16,30. The moat regions form the source 10 and drain 14 of TN1, the source 46 and drain 44 of TN2, the source 36 and drain 32 of DN4 and the source 38 and drain 42 of DN3. The interconnect is shown as a single mask process (e.g. using selective epitaxial silicon as an interconnect), however, a different method may be utilized. The source/drain regions and gate layer are n+ in doping and all transistors shown are fabricated in bulk silicon. The gates, moats, and interconnects may or may not be silicided depending on the choice of device technology. All of these regions can be seen in the schematic of FIG. 3., and the cross-sections of DN3 and DN4 are shown in FIG. 2.

In FIG. 1b, a layer of poly-Si is formed to create the bottom capacitor plates 50,52 (simultaneously a bit line landing pad 58 may be formed). The first bottom capacitor plate 50 is connected to DN4's gate 34 via contact hole 54 and the second bottom capacitor plate 52 is connected to DN3's gate 40 via contact hole 56. Note that the bottom capacitor plates 50,52 are much wider than the underlying gates 34,40, shown in FIG. 1b. Also, the plates 50,52 are along the oxide sidewalls, shown in FIG.2, resulting in large vertical area of the bottom capacitor plates. These factors will result in a substantially increased coupling capacitance in the final device. If the bottom capacitor plates 50,52 were not used, the drive transistor gates 34,40 would serve as bottom plates, but this would result in a significant decrease in coupling capacitance.

A layer of dielectric material 68 (FIG. 2) is formed over the bottom capacitor plates 50,52. This layer may be oxide, nitride, oxide/nitride, tantalum oxide, or any dielectric whose presence will not create instabilities in the drive transistors. Adjacent to bottom capacitor plates 50,52 the dielectric material 68 may be thin, thereby increasing the coupling capacitance in the final device.

Top capacitor plates 20,26 of poly-Si are formed on top of the dielectric layer, as shown in FIG. 1c. Note that only the top capacitor plates are marked in FIG. 1c for improved clarity. The first top capacitor plate 20 serves as load transistor LP5's gate 20 and the second top capacitor plate 26 serves as load transistor LP6's gate 26. The first top capacitor plate 20 is connected to DN3's gate 40 via contact hole 74 and the second top capacitor plate 26 is connected to DN4's gate 34 via contact hole 72. The top capacitor plates 20,26 overlap the portions of the bottom capacitor plates 50,52 which are over the drive transistor gates 34,40. The result is a significant increase in the coupling capacitance, due to the increase in the area of the resulting capacitor, when the bottom capacitor plates 50,52 are present.

After formation of the top capacitor plates 20,26 the PMOS channel film, including source and drain regions 18,22,24,28 (FIG. 2), is formed and connected to appropriate underlying layers. The channel region of the PMOS load transistors LP5 and LP6 may be defined using a resist mask. The significant portions of the device are complete and the remainder of the processing, such as metal layers, may be continued in the standard manner for SRAM devices.

A preferred embodiment has been described in detail hereinabove. It is to be understood that the scope of the invention also comprehends embodiments different from those described, yet within the scope of the claims. While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

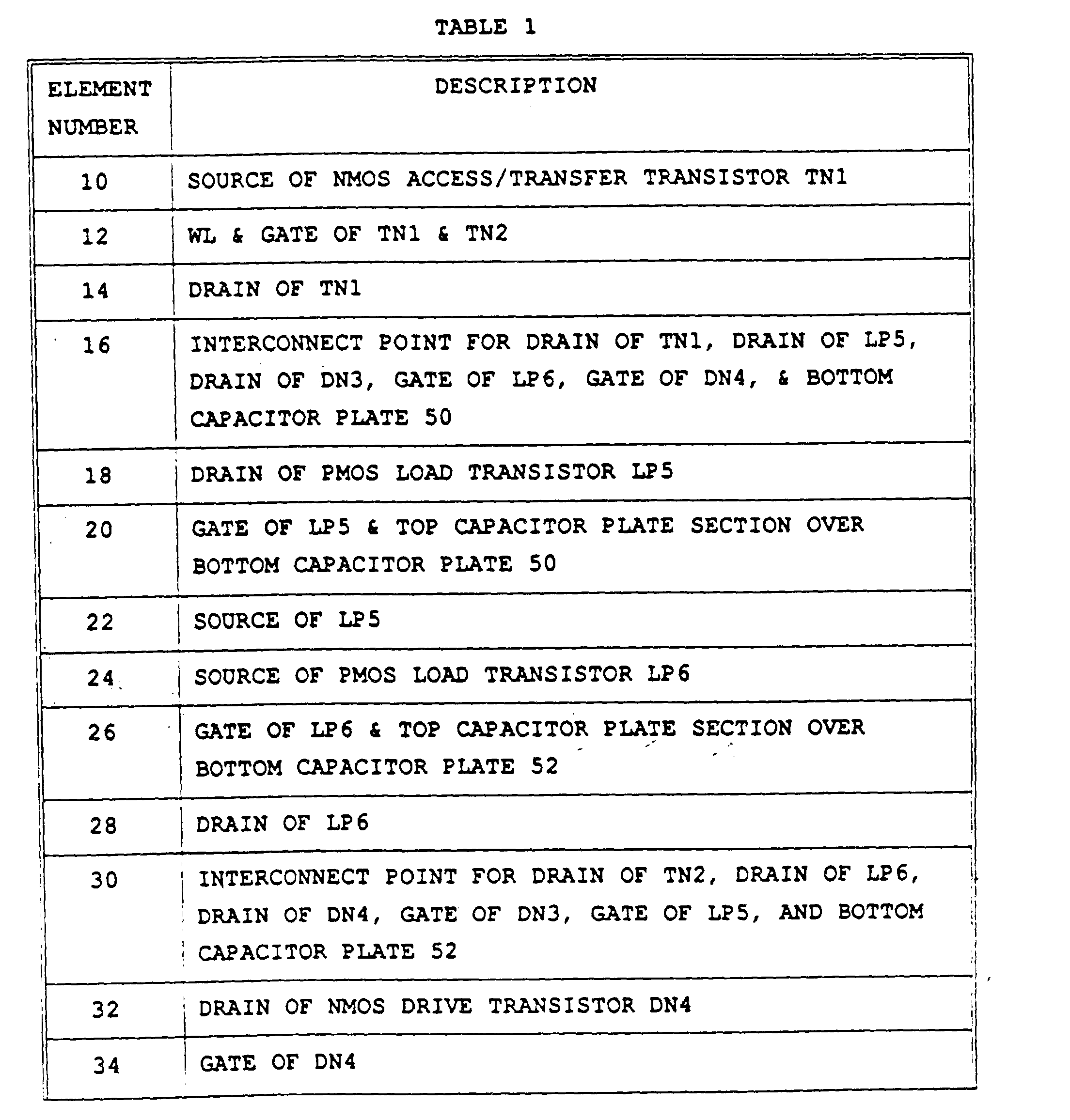

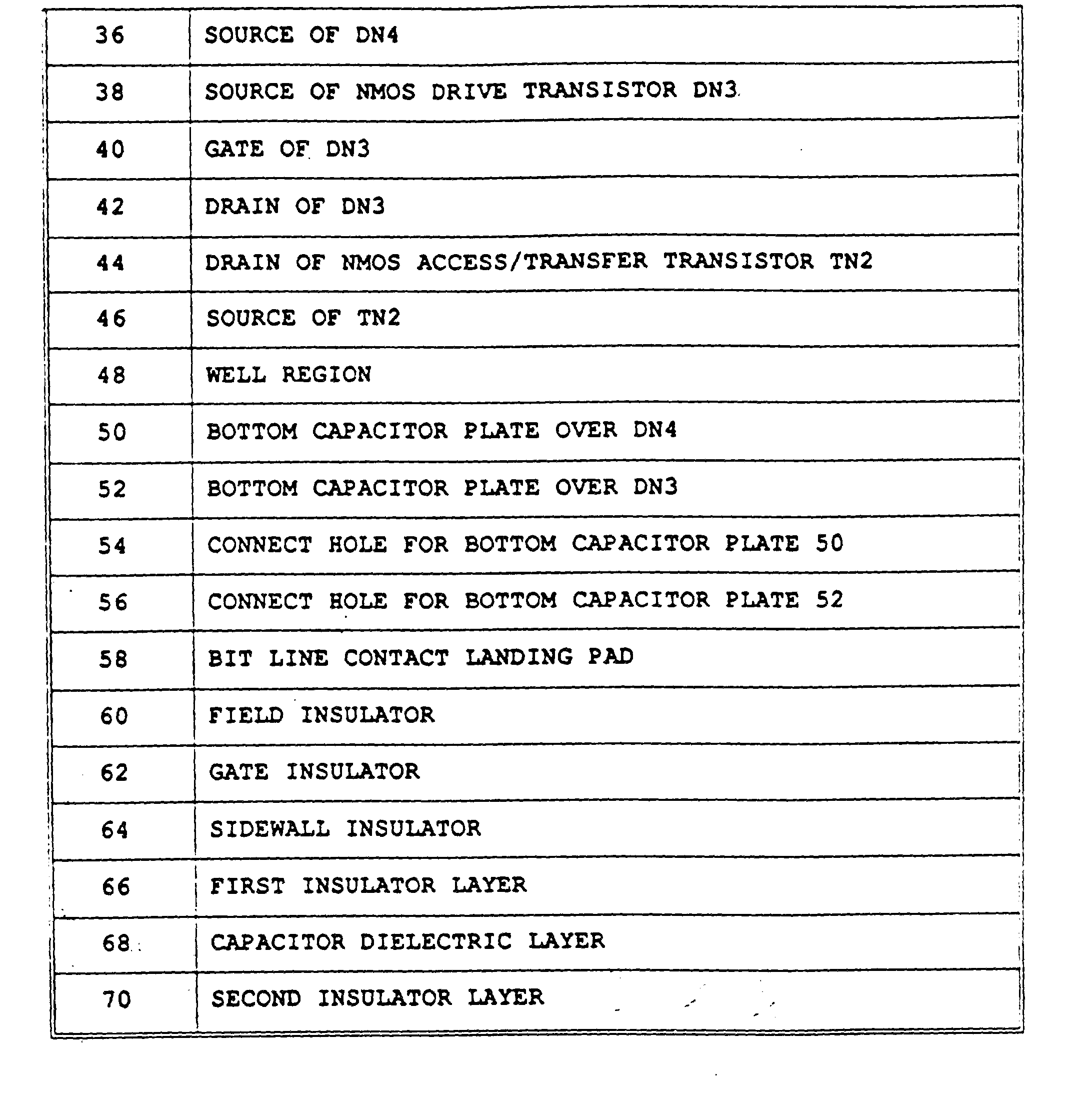

## Claims

1. An SRAM cell, said cell comprising:
a. two NMOS drive transistors;
b. two PMOS load transistors, said transistors forming two cross-coupled CMOS inverters
c. first (50) and second (52) bottom capacitor plates, with said first plate (50) being positioned over and connected to a gate (34) of one of said drive transistors and said second plate being positioned over and connected to a gate (40) of another of said drive transistors;
d. a layer of dielectric material (68) over said first (50) and second (52) bottom capacitor plates; and
e. first (20) and second (26) top capacitor plates being positioned over said dielectric layer (68), with said first top capacitor plate (20) forming a gate of one of said load transistors and with said second top capacitor plate (26) forming a gate of another one of said load transistors, whereby the capacitor plates form two capacitors connected in parallel between the gates (34,40) of the drive transistors and the stability of the cell is enhanced.

2. The cell of claim 1, wherein said dielectric material is oxide.

3. The cell of claim 1, wherein said dielectric material is nitride.

4. The cell of claim 1, wherein said dielectric material is tantalum oxide.

5. The cell of claim 1, wherein said dielectric material contains oxide and nitride.

6. A method of forming an SRAM cell, by forming first and second NMOS drive transistors, and first and second PMOS load transistors, said transistors forming two cross-coupled CMOS inverters said method further comprising:
a. forming a first bottom capacitor plate (50) being positioned over a gate (34) of said second drive transistor and second bottom capacitor plate (52) being positioned over a gate (40) of said first drive transistor;
b. electrically connecting said first bottom capacitor plate (50) to said second drive transistors gate (34);
c. electrically connecting said second bottom capacitor plate (52) to said first drive transistor gate (40);
d. forming dielectric layer (68) over said first (50) and second (52) bottom capacitor plates;
e. forming first (20) and second (26) top capacitor plates over said dielectric layer (68), with said first top capacitor plate (20) forming a gate of said first load transistor and being positioned over said first bottom capacitor plate (50), and said second top capacitor plate (26) forming a gate of said second load transistor and being positioned over said second bottom capacitor plate (52);
f. electrically connecting said first top capacitor plate (20) to said first drive transistor gate (40);
g. electrically connecting said second top capacitor plate (26) to said second drive transistor gate (34); and
h. forming PMOS channel films over said first (20) and second (26) top capacitor plates.

7. The method of claim 6, wherein said first (50) and second (52) bottom capacitor plates are fabricated from silicon.

8. The method of claim 6, wherein said first (20) and second (26) top capacitor plates are fabricated from silicon.

9. The method of claim 6, wherein said first (50) and second (52) bottom capacitor plates are over gate sidewalls of said drive transistors.

10. The method of claim 6, wherein said first (20) and second (26) top capacitor plates are over gate sidewalls of said drive transistors.

11. The method of claim 6, wherein said dielectric layer (68) is oxide.

12. The method of claim 6, wherein said dielectric layers (68) is nitride.

13. The method of claim 6, wherein said dielectric layer (68) is tantalum oxide.

14. The method of claim 6, wherein said dielectric layer (68) contains oxide and nitride.

## Patentansprüche

1. SRAM-Zelle mit :
a. zwei NMOS-Treibertransistoren;
b. zwei PMOS-Lasttransistoren, wobei diese Transistoren zwei über Kreuz gekoppelte CMOS-Inverter bilden;
c. ersten (50) und zweiten (52) unteren Kondensatorbelägen, wobei der erste Belag (50) über und in Verbindung mit einem Gate (34) eines der Ansteuertransistoren angeordnet ist und der zweite Belag über und in Verbindung mit einem Gate (40) eines weiteren der Ansteuertransistoren angeordnet ist;
d. einer Schicht (68) aus dielektrischem Material über den ersten (50) und zweiten (52) unteren Kondensatorbelägen; und
e. ersten (20) und zweiten (26) oberen Kondensatorbelägen, die über der dielektrischen Schicht (68) angeordnet sind, wobei der erste obere Kondensatorbelag (20) ein Gate eines der Lasttransistoren bildet und der zweite obere Kondensatorbelag (26) ein Gate eines weiteren der Lasttransistoren bildet, wodurch die Kondensatorbeläge zwei parallelgeschaltete Kondensatoren zwischen den Gates (34, 40) der Treibertransistoren bilden und die Stabilität der Zelle verbessert wird.

2. Zelle nach Anspruch 1, bei welcher das dielektrische Material Oxid ist.

3. Zelle nach Anspruch 1, bei welcher das dielektrische Material Nitrid ist.

4. Zelle nach Anspruch 1, bei welcher das dielektrische Material Tantaloxid ist.

5. Zelle nach Anspruch 1, bei welcher das dielektrische Material Oxid und Nitrid enthält.

6. Verfahren zum Herstellen einer SRAM-Zelle durch Bilden erster und zweiter NMOS-Treibertransistoren und erster und zweiter PMOS-Lasttransistoren, wobei die ersten Transistoren zwei über Kreuz gekoppelte CMOS-Inverter bilden, wobei das Verfahren ferner enthält:
a. Bilden eines ersten unteren Kondensatorbelags (50), der über einem Gate (34) des zweiten Treibertransistors angeordnet ist, sowie eines zweiten unteren Kondensatorbelags (52), der über einem Gate (40) des ersten Treibertransistors angeordnet ist;
b. elektrisches Verbinden des ersten unteren Kondensatorbelags (50) mit dem Gate (34) des zweiten Treibertransistors;
c. elektrisches Verbinden des zweiten unteren Kondensatorbelags (52) mit dem Gate (40) des ersten Treibertransistors;
d. Bilden einer dielektrischen Schicht (68) über den ersten (50) und zweiten (52) unteren Kondensatorbelägen;
e. Bilden erster (20) zweiter (26) oberer Kondensatorbeläge über der dielektrischen Schicht (68), wobei die ersten oberen Kondesatorbeläge (20) ein Gate des ersten Lasttransistors bilden und über den ersten unteren Kondensatorbelag (50) angeordnet ist, und wobei der zweite obere Kondensatorbelag (26) ein Gate des zweiten Lasttransistors bildet und über den zweiten unteren Kondensatorbelag (52) angeordnet ist;
f. elektrisches Verbinden des ersten oberen Kondensatorbelags (20) mit dem Gate (40) des ersten Treibertransistors;
g. elektrisches Verbinden des zweiten oberen Kondensatorbelags (26) mit dem Gate (34) des zweiten Treibertransistors; und
h. Bilden von PMOS-Kanal-Filmen über den ersten (20) und zweiten (26) oberen Kondensatorbelägen.

7. Verfahren nach Anspruch 6, bei welchem die ersten (50) und zweiten (52) unteren Kondensatorbeläge aus Silizium hergestellt werden.

8. Verfahren nach Anspruch 6, bei welchem die ersten (20) und zweiten (26) oberen Kondensatorbeläge aus Silizium hergestellt werden.

9. Verfahren nach Anspruch 6, bei welchem die ersten (50) und zweiten (52) unteren Kondensatorbeläge über Gate-Seitenwänden der Treibertransistoren liegen.

10. Verfahren nach Anspruch 6, bei welchem die ersten (20) und zweiten (26) oberen Kondensatorbeläge über Gate-Seitenwänden der Treibertransistoren liegen.

11. Verfahren nach Anspruch 6, bei welchem die dielektrische Schicht (68) Oxid ist.

12. Verfahren nach Anspruch 6, bei welchem die dielektrische Schicht (68) Nitrid ist.

13. Verfahren nach Anspruch 6, bei welchem die dielektrische Schicht (68) Tantaloxid ist.

14. Verfahren nach Anspruch 6, bei welchem die dielektrische Schicht (68) Oxid und Nitrid enthält.

## Revendications

1. Cellule SRAM, ladite cellule comprenant :
a. deux transistors d'attaque NMOS ;
b. deux transistors de charge PMOS, lesdits transistors formant deux inverseurs CMOS rétrocouplés ;
c. des première (50) et seconde (52) plaques de condensateur inférieures, avec ladite première plaque (50) positionnée sur et connectée à une grille (34) d'un desdits transistors d'attaque et ladite seconde plaque positionnée sur et reliée à une grille (40) d'un autre desdits transistors d'attaque ;
d. une couche d'un matériau diélectrique (68) sur lesdites première (50) et seconde (52) plaques de condensateur inférieures ; et
e. des première (20) et seconde (26) plaques de condensateur supérieures étant positionnées sur ladite couche (68) diélectrique avec ladite première plaque de condensateur supérieure (20) formant une grille d'un desdits transistors de charge et avec ladite seconde plaque de condensateur supérieure (26) formant une grille d'un autre desdits transistors de charge, de sorte que les plaques de condensateur forment deux condensateurs reliés en parallèle entre les grilles (34, 40) des transistors d'attaque et que la stabilité de la cellule est améliorée.

2. Cellule selon la revendication 1, dans laquelle ledit matériau diélectrique est un oxyde.

3. Cellule selon la revendication 1, dans laquelle ledit matériau diélectrique est du nitrure.

4. Cellule selon la revendication 1, dans laquelle le matériau diélectrique est de l'oxyde de tantale.

5. Cellule selon la revendication 1, dans laquelle ledit matériau diélectrique contient de l'oxyde et du nitrure.

6. Procédé pour former une cellule SRAM : en formant des premier et second transistors d'attaque NMOS et des premier et second transistors de charge PMOS, lesdits transistors formant deux inverseurs CMOS retro-couplés, ledit procédé comprenant en outre :
a. former une première plaque de condensateur inférieure (50) positionnée sur une grille (34) dudit second transistor d'attaque et une seconde plaque de condensateur inférieure (52) positionnée sur une grille (40) dudit premier transistor d'attaque ;
b. relier électriquement ladite première plaque de condensateur inférieure (50) à ladite grille (34) du second transistor d'attaque ;
c. relier électriquement ladite seconde plaque de condensateur inférieure (52) à ladite grille (40) du premier transistor d'attaque ;
d. former une couche (68) diélectrique sur lesdites première (50) et seconde (52) plaques de condensateur inférieures ;
e. former des première (20) et seconde (26) plaques de condensateur supérieures sur ladite couche diélectrique (68) avec ladite première plaque de condensateur supérieure (20) formant une grille dudit premier transistor de charge et positionnée sur ladite première plaque de condensateur inférieure (50), et ladite seconde plaque de condensateur supérieure (26) formant une grille dudit second transistor de charge et positionnée sur ladite seconde plaque de condensateur inférieure (52) ;
f. relier électriquement ladite première plaque de condensateur supérieure (20) à ladite grille (40) du premier transistor d'attaque ;
g. relier électriquement ladite seconde plaque de condensateur supérieure (26) à ladite grille (34) du second transistor d'attaque ; et
h. former des films de canaux PMOS sur lesdites première (20) et seconde (26) plaques de condensateur supérieures.

7. Procédé selon la revendication 6, dans lequel ladite première (50) et seconde (52) plaques de condensateur inférieures sont fabriquées à partir de silicium.

8. Procédé selon la revendication 6, dans lequel ladite première (20) et seconde (26) plaques de condensateur supérieures sont fabriquées à partir de silicium.

9. Procédé selon la revendication 6, dans lequel lesdites première (50) et seconde (52) plaques de condensateur inférieures sont sur des parois latérales de grille desdits transistors d'attaque.

10. Procédé selon la revendication 6, dans lequel lesdites première (20) et seconde (26) plaques de condensateur supérieures sont sur des parois latérales de grille desdits transistors d'attaque.

11. Cellule selon la revendication 6, dans laquelle ladite couche diélectrique (68) est un oxyde.

12. Cellule selon la revendication 6, dans laquelle ladite couche diélectrique (68) est du nitrure.

13. Cellule selon la revendication 6, dans laquelle la couche diélectrique (68) est de l'oxyde de tantale.

14. Cellule selon la revendication 6, dans laquelle ladite couche diélectrique (68) contient de l'oxyde et du nitrure.
